(19) Europäisches Patentamt / European Patent Office / Office européen des brevets

(11) **EP 3 077 569 B1**

(12) **FASCICULE DE BREVET EUROPEEN**

(45) Date de publication et mention
de la délivrance du brevet:
**16.08.2017   Bulletin 2017/33**

(21) Numéro de dépôt: **14825399.0**

(22) Date de dépôt: **01.12.2014**

(51) Int Cl.:
*C23C 18/00* (2006.01)          *F01D 5/00* (2006.01)
*F01D 5/28* (2006.01)          *C23C 26/00* (2006.01)
*C23C 28/00* (2006.01)          *C23C 16/40* (2006.01)
*C23C 10/04* (2006.01)          *C23C 16/04* (2006.01)
*C23C 16/455* (2006.01)          *F01D 5/18* (2006.01)
*B05B 15/04* (2006.01)          *C25D 5/02* (2006.01)
*B05D 3/04* (2006.01)          *B05D 1/32* (2006.01)

(86) Numéro de dépôt international:
**PCT/FR2014/053103**

(87) Numéro de publication internationale:
**WO 2015/082819 (11.06.2015 Gazette 2015/23)**

(54) **PROCEDE ET SYSTEME DE DEPÔT D'OXYDE SUR UN COMPOSANT POREUX**

VERFAHREN UND SYSTEM ZUR OXIDABLAGERUNG AUF EINER PORÖSEN SUBSTANZ

METHOD AND SYSTEM FOR DEPOSITING OXIDE ON A POROUS COMPONENT

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **02.12.2013   FR 1361945**

(43) Date de publication de la demande:
**12.10.2016   Bulletin 2016/41**

(73) Titulaire: **Office National d'Etudes et de
Recherches
Aérospatiales (ONERA)
91120 Palaiseau (FR)**

(72) Inventeurs:
• **BACOS, Marie-Pierre**
  **F-92160 Antony (FR)**
• **ROUSSEAU, Frédéric**
  **F-51260 Esclavolles Lurey (FR)**
• **MORVAN, Daniel**
  **F-75005 Paris (FR)**

(74) Mandataire: **de Kernier, Gabriel
Cabinet Netter
Conseils en Propriété Industrielle
36, avenue Hoche
75008 Paris (FR)**

(56) Documents cités:
**EP-A1- 1 010 772          FR-A1- 2 729 400
US-A- 5 399 388          US-B1- 6 365 013**

• **ROUSSEAU F ET AL: "Deposition of thick and
50% porous YpSZ layer by spraying nitrate
solution in a low pressure plasma reactor",
SURFACE AND COATINGS TECHNOLOGY, vol.
206, no. 7, 29 juin 2011 (2011-06-29) , pages
1621-1627, XP028126180, ISSN: 0257-8972, DOI:
10.1016/J.SURFCOAT.2011.06.024 [extrait le
2011-06-29] cité dans la demande**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

EP 3 077 569 B1

**Description**

L'invention concerne un procédé pour le dépôt d'oxyde sur des composants perméables à revêtir en surface. L'utilisation de composants à porosité ouverte, comme par exemple ceux munis de canaux de refroidissement, est courante pour de nombreuses applications. Parmi celles-ci figurent les aubes des turbines haute pression de turbomachines, notamment d'aviation, et les chambres de combustion aéronautiques ou terrestres. Les aubes de turbines sont typiquement refroidies par de l'air, prélevé au niveau du compresseur, air qui est injecté dans le pied de l'aube (pied de sapin) et qui traverse l'aube au travers de canaux débouchant en surface, et plus particulièrement près du bord d'attaque et au bord de fuite. US 7670112 et US 6126396 donnent des exemples d'aubes refroidies par des multicanaux.

Les chambres de combustion des moteurs possèdent également des canaux ou cavités de refroidissement. De nombreux exemples de ce type de chambre sont publiés dans la littérature, comme par exemple US 5775108 et EP 0892218 ou S. Angel et al dans High temperature material process 11 (2007) 321-342.

L'utilisation de canaux de refroidissement alliée à un dépôt d'une barrière thermique en surface, comme par exemple l'oxyde de zirconium partiellement stabilisé à l'oxyde d'yttrium, permet l'utilisation de ces composants de moteur à des températures surfaciques supérieures à la température de brûlure ou de fusion du métal constitutif du composant. Typiquement ces barrières thermiques sont déposées sur le composant à revêtir soit par une technique de projection (en particulier la projection thermique telle que *Air Plasma Spray* (APS) ou *Low Pressure Plasma Spray* (LPPS) ou *High Velocity Oxy Fuel* (HVOF)) soit par dépôt par voie physique en phase vapeur c'est-à-dire par évaporation (en particulier par EB-PVD ou *Electron Beam Physical Vapeur Deposition*). Des techniques alternatives à la technique de projection thermique plasma usuellement utilisée ont été également publiées comme les procédés appelés SCP (*Spray Conversion Processing*) ou SPPS (*Solution Precursor Plasma Spray*) décrits par les publications US 6025034, US 2003/0077398. D'autres techniques d'élaboration de céramiques oxydes épaisses ou de barrières thermiques existent telles que le dépôt chimique en phase vapeur simple (CVD *Chemical Vapeur Deposition*) ou assisté plasma (PE-CVD *Plasma Enhanced - Chemical Vapeur Deposition*) publié dans FR 2695944 , la voie sol-gel publiée dans US 5585136 ou le procédé LPPR *Low Pressure Plasma Reactor* publié par Rousseau al (Deposition of thick and 50% porous YpSZ layer by spraying nitrate solution in a low pressure plasma reactor, Surface and Coating Technology 206 (7) (2011) 1621-1627). Cet article divulgue un procédé de formation d'une barrière thermique poreuse sur un substrat d'alumine non poreux.

Les barrières thermiques déposées peuvent être à base d'oxyde de zirconium ou zircone, particulièrement l'oxyde de zirconium stabilisé à l'oxyde d'yttrium appelé également zircone yttriée ou YpSZ pour *«Yttria partially Stabilized Zirconia»*, l'oxyde de cérium, l'oxyde de magnésie ou de tout autre oxyde.

En général pour les composants du genre chambre de combustion, la barrière thermique est déposée par projection plasma. Pour des composants du genre chambre de combustion multi perforées, dans lesquelles le refroidissement se fait par injection localisée et où la partie métallique est dense et non poreuse, le perçage se fait sur le système complet - chambre de combustion revêtue de la barrière thermique -, donc après le dépôt de la barrière thermique. Pour les composants du genre chambre de combustion transpirante, dans lesquelles le refroidissement se fait par transpiration ou effusion et où la partie métallique possède une forte porosité ouverte - par exemple constituée d'éponge métallique ou d'empilement de sphères creuses - le perçage a lieu uniquement dans la barrière thermique après dépôt de celle-ci. Mais l'opération de perçage est une opération longue et coûteuse qui nécessite un outillage sophistiqué et coûteux à l'achat comme un laser robotisé perfectionné. De plus dans le cas des chambres de combustion dite transpirante le perçage laser peut entraîner des dégradations élevées telles que celles décrites par S. Angel et al dans High temperature material process 11 (2007) 321-342 dans le cas d'une mousse métallique à porosité ouverte surmontée d'une barrière thermique d'oxyde de zirconium stabilisée par l'oxyde d'yttrium.

Pour les aubes de turbine souvent revêtues par une barrière thermique par EB-PVD (*Electron Beam Physical Vapor Deposition*) ou PVD (*Physical Vapor Deposition*), les canaux de refroidissement sont percés sur le composant métallique avant le dépôt de la sous-couche métallique typiquement réalisé par procédé d'aluminisation thermochimique et de la barrière thermique déposée par EB-PVD. Même si avec les techniques employées les vitesses de dépôt sont assez faibles (comparées à la projection plasma) il y a nécessité après dépôt de la barrière thermique de déboucher les canaux car une partie du dépôt pénètre dans les canaux comme indiqué dans la figure 4 de la publication US 6408610.

L'obstruction des trous de ces canaux de refroidissement lors du dépôt de la barrière thermique a pour conséquence l'apparition de points localement très chauds entraînant des fissurations ou des fusions locales du métal de l'aube et la dégradation de la barrière thermique. C'est pourquoi de nombreux procédés ont été publiés afin d'empêcher ce phénomène d'obstruction ou de colmatage des trous lors du dépôt d'une barrière thermique et afin d'éviter l'opération de débouchage suite au dépôt de la barrière thermique.

De nombreuses publications proposent des solutions pour éviter l'obturation des trous en utilisant des bouchons qui se volatilisent par la suite, ou des masques qui doivent être placés individuellement dans chaque trou, cf US 4743462, ou dans plusieurs trous à la fois, cf US 5985122, US 6258226, US 5565035 et US 5800695. Mais toutes ces solutions sont coûteuses en temps et en outillage.

D'autres solutions consistent à injecter dans le composant de l'eau sous très forte pression, cf US 6004620, avec ou sans un produit agressif du type soude, cf US 6210488, ou d'injecter un abrasif, cf US 5702288, afin de déboucher les canaux. Mais ce type de procédé crée des pollutions dans les canaux de refroidissement qui sont nuisibles par la suite. Enfin des techniques laser, cf US 5216808, enlèvent localement la barrière thermique qui a colmaté les trous mais ces techniques sont complexes car elles doivent être alliées à des machines de reconnaissance des porosités dans les composants.

La Demanderesse a établi au cours de ses recherches que la seule possibilité d'éviter toutes ces opérations de débouchage après dépôt de la barrière thermique est d'empêcher le dépôt de la barrière thermique de se produire dans la porosité ouverte.

Pour la formation de la sous-couche métallique de la barrière thermique, EP 1 010 772 divulgue un procédé permettant d'éviter le colmatage de canaux de refroidissement d'une aube à partir d'un gaz, dont la pression est contrôlée expérimentalement en fonction du composant à traiter, gaz injecté à travers le composant en flux opposé aux précurseurs arrivant sur le composant à l'état gazeux. Comme indiqué supra, les précurseurs de l'aluminisation sont gazeux et il s'agit d'un procédé d'aluminisation en phase vapeur dans lequel la température nécessaire pour générer les précurseurs du dépôt est bien connue de l'homme du métier comme typiquement d'environ 1000-1100°C, le composant à traiter étant à la même température pour que la réaction ait lieu

Pour les barrières thermiques elle mêmes, dépôts d'oxyde réalisés à partir de précurseurs gazeux (Physical Vapor Deposition ou Gas jet Sputter process) ou fondus (projection plasma par faisceau d'ions) US 6 365 013 divulgue que la réduction de l'obstruction des trous d'un composant perméable par surpression de gaz injecté au travers de la porosité du composant en flux opposé aux précurseurs de la barrière thermiques, nécessite le préchauffage entre 100 et 900°C des gaz à injecter et ne s'applique qu'à des composants dans la surface totale débouchante est faible, typiquement inférieure à 2% de la surface totale du composant.

Pour les barrières thermiques déposées par projection plasma (par torche), US 4 402 992 présente un système permettant de réduire l'obstruction des trous grâce à un système de gaz neutre injecté au travers des canaux de refroidissement pour obtenir une réduction de l'obstruction de trous de diamètre compris entre 254 et 508 $\mu$m avec ce procédé il est nécessaire d'injecter une très forte pression de gaz neutre, s'élevant à 551580 Pa (80psia), et un débit massique compris entre 2,2 à 6,8 $10^{-3}$ kg/s (0,005 à 0,015 $lb_m$/s) correspondant à un débit volumique d'argon de 77 à 231 L/min. Ce procédé est donc limité à de fortes pressions de gaz d'injection et aux gaz neutres uniquement. De plus ce procédé coûteux en énergie et en gaz, ne permet pas d'éviter le colmatage de la totalité des trous. Enfin les conditions expérimentales créent des effets de turbulence à la surface du composant à traiter ce qui interfère sur la qualité et l'uniformité du dépôt.

L'invention vise à remédier aux inconvénients des techniques ci-dessus, identifiés par la Demanderesse. La Demanderesse a établi qu'un besoin existait de revêtir avec un revêtement de haute qualité à base d'oxyde des composants perforés avec conservation élevée des perforations ouvertes sur la surface à revêtir. Il existe un intérêt à revêtir un composant à grande porosité ouverte, c'est-à-dire dont la valeur du rapport de la surface débouchante des trous sur la surface totale externe du composant à revêtir peut atteindre 30%, voire plus.

Plus particulièrement, l'invention propose un procédé permettant de déposer, sur un composant perméable, un oxyde sans colmater les porosités ouvertes sur une grande gamme de variation de la valeur de la surface débouchante des trous par rapport à la surface du composant, en utilisant une double injection contrôlée, d'une part, l'injection d'un gaz porteur ou d'un mélange de gaz porteur chargé dans un plasma basse pression où sont introduits des précurseurs de l'oxyde à l'état liquide, gel ou solide et, d'autre part, l'injection d'un fluide traversant le composant perméable et sortant de celui-ci à l'état gazeux à flux opposé à celui du gaz porteur, avec un faible débit massique.

Selon un aspect de l'invention, un procédé de formation d'une couche d'oxyde sur un composant perméable réalisé en un matériau ou un empilement de matériaux stable à 400°C, ledit composant comprenant une surface extérieure à revêtir et au moins un pore de diamètre compris entre 50 et 1000 $\mu$m débouchant sur la surface extérieure, comprend les étapes suivantes :

a) Injection d'un gaz porteur chargé de gouttelettes d'au moins un précurseur de l'oxyde dans un plasma basse pression au sein d'une enceinte de réacteur à plasma logeant le composant à revêtir, et injection d'un fluide passant par le composant perméable et s'écoulant à l'état gazeux par ledit au moins un pore à flux opposé à celui du gaz porteur dans la chambre à plasma pour éviter le colmatage du pore, la pression et le débit massique dudit fluide en amont du composant perméable étant tels que la pression du gaz en sortie du au moins un pore est supérieure à la pression dans la chambre à plasma et que le débit massique d'injection du fluide passant par le composant perméable est :

α) au maximum égal au débit massique du gaz porteur chargé en précurseurs de l'oxyde injecté dans la chambre à plasma ; et
β) au minimum égal au produit du débit massique du gaz porteur chargé en précurseurs de l'oxyde injecté dans la chambre à plasma par le rapport entre la surface totale des porosités ouvertes du composant perméable et la surface de la section de passage de la chambre à plasma ;

ainsi, la vitesse du gaz à la sortie du au moins un pore est supérieure ou égale à la vitesse d'arrivée du gaz porteur chargé d'au moins un précurseur de l'oxyde à l'état indifféremment - liquide, gel ou solide - à la surface extérieure du composant.

Au-dessus de la borne supérieure, le plasma risque de s'éteindre. Au-dessous de la borne inférieure, la vitesse du gaz en sortie des trous est trop faible.

En effet, la vitesse en sortie d'une porosité dépend uniquement du débit massique du fluide injecté et de la surface de sortie du trou. Par ailleurs, l'homme du métier trouvera les enseignements nécessaires pour définir l'état de son choix du précurseur dans la demande de brevet déposée sous le numéro FR13.0061944 le 2 décembre 2013 par la Demanderesse de la présente demande.

b) Injection du gaz porteur non chargé de précurseur de l'oxyde dans un plasma au sein de la chambre à plasma, l'injection du fluide passant par le composant perméable étant maintenu

les étapes a) et b) étant répétées, pour former sur la surface extérieure ledit oxyde, le diamètre du au moins un pore étant préservé.

L'injection contrôlée dudit fluide a lieu au travers du composant perméable à flux opposé aux précurseurs de l'oxyde introduits dans le plasma. Le fluide injecté dans le composant perméable crée une surpression (gazeuse) locale au niveau de la porosité ouverte s'opposant à la formation de dépôt dans les pores débouchants. L'injection peut être paramétrée en fonction de la pression du réacteur, de la vitesse du gaz porteur chargé en précurseurs de l'oxyde injectés dans la chambre à plasma et de la perméabilité du composant perméable à revêtir. L'injection peut être contrôlée par la mesure de la pression du fluide injecté en amont du composant perméable à revêtir et du débit massique dudit fluide d'injection. Optionnellement un asservissement entre les paramètres pression du réacteur, débit massique du gaz porteur chargé en précurseurs de l'oxyde, débit massique du fluide d'injection passant par le matériau perméable et pression en amont du composant perméable à revêtir peut être réalisé afin de s'assurer que le régime soit laminaire (nombre de Reynolds inférieur à 2100). Le fluide utilisé peut être de l'air, un gaz neutre, de l'eau ou un autre solvant compatible chimiquement avec le composant à revêtir. La conservation d'un régime sensiblement non turbulent réduit le risque de désamorcer le plasma dans le réacteur.

L'invention offre un procédé peu énergétique où le composant perméable (à porosité ouverte) à revêtir reste à basse température lors du dépôt (température maximale 400°C) ce qui permet l'utilisation de fluide oxydant par exemple air, eau, au travers dudit composant. Le dépôt se fait à basse pression, par exemple choisie entre 1 et 20000 Pa, ce qui permet d'éviter l'obstruction des pores en appliquant un débit et une pression supérieure en amont du composant perméable à revêtir, par exemple choisie entre 10 et 40000 Pa, donc en dessous de la pression atmosphérique. Le dépôt peut être effectué avec des précurseurs de l'oxyde, par exemple des céramiques, liquide, gel ou solide, (tels que des nitrates, des acétates, des chlorures ou autre organométallique liquide). Les diamètres des précurseurs de l'oxyde peuvent être compris entre 100 nm et 2 mm injectés dans un plasma de puissance comprise entre 60 et 20000 W. On entend par précurseur de l'oxyde un objet chimique contenant au moins un élément de l'oxyde et permettant d'amorcer une réaction de formation de dudit oxyde.

Dans un mode de réalisation, les paramètres du procédé permettant le dépôt de l'oxyde : débit massique du gaz porteur chargé de gouttelettes de précurseur de l'oxyde, taille des gouttelettes de précurseur de l'oxyde, pression de la chambre à plasma et puissance du plasma sont déterminés au préalable.

Dans un mode de réalisation, l'injection d'un fluide en amont et au travers d'un composant perméable est réalisée tout en commandant la pression de ce fluide en amont, Dans un mode de réalisation la valeur de la pression dudit fluide en amont du composant perméable est déterminée en fonction de la géométrie et de la perméabilité du composant, telle que la pression du gaz en sortie de la porosité ouverte soit toujours supérieure à la pression de la chambre à plasma.

Dans un mode de réalisation, le système d'injection en fluide du composant perméable est régulé à l'aide d'un débitmètre massique de manière que la vitesse du gaz en sortie de la porosité ouverte soit supérieure à la vitesse d'arrivée des précurseurs de l'oxyde à la surface du matériau perméable, et ce en conservant la stabilité du plasma et la laminarité du flux.

Dans un mode de réalisation, un asservissement entre la pression du fluide d'injection en amont du composant, la pression de la chambre à plasma et le débit massique du gaz porteur chargé en précurseurs de l'oxyde est mis en oeuvre afin de piloter le débit massique du fluide injecté dans le composant perméable dans les bornes définies en $\alpha$) et $\beta$) tout en conservant un nombre de Reynolds inférieur à 2100 quel que soit le débit massique du gaz porteur chargé en précurseurs de l'oxyde.

Dans un mode de réalisation, la pression dans la chambre à plasma est comprise entre 1 et 20000 Pa, préférablement entre 100 et 10000 Pa.

Dans un mode de réalisation, la puissance du générateur qui délivre les ondes électromagnétiques pour créer le plasma est comprise entre 60 et 20000 W, préférablement entre 200 et 10000 W.

Dans un mode de réalisation, le fluide passant par le composant perméable est à l'état gazeux et le précurseur de l'oxyde est à l'état liquide, gel ou solide. Le fluide ne perturbe guère le précurseur d'oxyde. Le fluide peut être choisi parmi l'air, les gaz neutres, l'eau et les solvants compatibles chimiquement avec le composant à revêtir.

Dans un mode de réalisation, le composant perméable présente des pores ouverts de diamètre compris entre 50 et 1000 $\mu$m. Le composant perméable peut être une pièce perforée avec des trous calibrés. Le composant perméable peut être une mousse. Le composant perméable peut être un feutre. Le composant perméable peut être un empilement de sphères creuses.

Dans un mode de réalisation, le précurseur de l'oxyde est un précurseur de céramique comprenant au moins un organo-métallique, préférablement nitrate, acétate et/ou chlorure.

Dans un mode de réalisation, le précurseur de l'oxyde comprend au moins un parmi les nitrates de zirconium, les nitrates d'yttrium, les nitrates de gadolinium et les nitrates d'europium, de concentration comprise entre 0,005 et 0,5 mole par litre,

Dans un mode de réalisation, la solution de précurseurs de l'oxyde, tels que des nitrates, des acétates, des chlorures ou tout autre organométallique liquide, est introduite par utilisation d'un injecteur, par exemple un spray, un jet, un nébuliseur, un atomiseur, permettant de produire des gouttelettes de diamètre compris entre 100 nm et 2 mm. Dans un mode de réalisation, l'injection est réalisée par un capillaire de diamètre compris entre 50 et 900 $\mu$m.

Dans un mode de réalisation, le procédé comprend des injections pulsées du gaz porteur chargé en précurseur de l'oxyde, suivies d'injection de gaz porteur non chargé en précurseur de l'oxyde, avec un rapport durée d'injection avec précurseurs de l'oxyde/durée d'injection sans précurseurs de l'oxyde entre 1/5 et 1/30.

Dans un mode de réalisation, ces étapes sont effectuées 6 à 30 fois.

Dans un mode de réalisation, le composant est neuf.

Dans un mode de réalisation, l'alliage comprend un superalliage à base de nickel.

L'alliage peut être monocristallin pour une aube ou polycristallin pour une chambre de combustion.

Dans un mode de réalisation, l'alliage comprend un superalliage à base de cobalt.

Dans un mode de réalisation, l'alliage comprend un superalliage à base de fer.

Dans un mode de réalisation, l'alliage comprend un superalliage à base de niobium.

Dans un mode de réalisation, l'alliage comprend un superalliage à base d'aluminium.

Dans un mode de réalisation, l'alliage comprend un superalliage à base de cuivre.

Dans un mode de réalisation, la pression du fluide passant par le composant perméable est comprise entre 10 et 40000 Pa, préférablement entre 200 et 20000 Pa.

Dans un autre mode de réalisation, le composant est en réparation.

Dans un mode de réalisation, le procédé pour réparer le composant comprend des injections pulsées du gaz porteur chargé en précurseur d'oxyde, suivies d'injection de gaz porteur non chargé en précurseur d'oxyde, avec un rapport durée d'injection avec précurseurs de l'oxyde/durée d'injection sans précurseurs de l'oxyde entre 1/5 et 1/30 avec, à partir d'un cycle déterminé, une diminution de la pression de la chambre à plasma en début de chaque cycle

Dans un mode de réalisation, le procédé pour réparer le composant comprend un asservissement entre la pression de la chambre à plasma, le débit massique du gaz porteur chargé en précurseurs de l'oxyde, le débit massique du fluide traversant le composant perméable et la pression en amont du fluide traversant le composant perméable.

D'autres caractéristiques et avantages de l'invention apparaîtront à l'examen de la description détaillée ci-après, et des dessins annexés, sur lesquels :

- la figure 1 est une vue en coupe d'un composant en super alliage équipé d'une couche d'oxyde ;
- la figure 2 est une vue en coupe d'un composant en inox équipé d'une couche d'oxyde;
- la figure 3 est une vue schématique d'un appareil de mise en oeuvre du procédé ;
- la figure 4 est un schéma général d'un appareil de mise en oeuvre du procédé ; et
- les figures 5a à 5c sont des vues d'un composant au cours des étapes du procédé ;

La Demanderesse s'est aperçu qu'une technique provenant des piles à combustible était intéressante. Le lecteur est invité à se référencer à FR 2 729 400 décrivant un procédé de dépôt d'une couche mince d'oxyde métallique pour une pile à combustible. Un substrat est placé dans une chambre à vide communiquant avec une chambre à plasma présentant une tuyère convergente débouchant dans la chambre à vide par un orifice de sortie disposé face au substrat et de diamètre compris entre 2 et 5 mm. La pression dans la chambre à vide est comprise entre 10 et 2000 Pa. On injecte continuellement dans la chambre à plasma cylindrique présentant une section de passage d'environ 16 cm$^2$ (diamètre de 4,5 cm) un faible débit d'un gaz porteur comprenant au moins l'élément oxygène et on génère un plasma dans la chambre à plasma par excitation électromagnétique du gaz porteur. On nébulise une solution aqueuse contenant au moins l'élément métallique, en générant ainsi un aérosol dans un gaz porteur chargé qui présente une pression supérieure à la pression régnant dans la chambre à vide et on fait entrer séquentiellement, par aspiration, des quantités prédéterminées du gaz porteur chargé d'aérosol dans la chambre à plasma. Cependant la technique telle que décrite par cette publication ne permet pas de recouvrir un composant perméable sans colmater ses porosités ouvertes, les particules de précurseurs ayant des diamètres compris entre 100 nm et 1 mm, comme divulgué par Cyril Fourmond dans "Synthèse d'oxydes par plasma. Mise au point d'un réacteur plasma pour les tests de résistante au CMAS. " Thèse de doctorat de l'Université Pierre et Marie Curie soutenue le 29 novembre 2011, ce qui correspond à la gamme de la taille des pores des matériaux poreux usuels. La partie des particules de précurseurs de l'oxyde dont le diamètre est inférieur à celui des pores débouchants peut s'infiltrer dans ces pores.

A partir du réacteur du procédé divulgué par FR 2 729 400, la Demanderesse a mis au point un procédé de formation de couche d'oxyde sur un substrat poreux en conservant les propriétés structurales et fonctionnelles desdites porosités une fois le revêtement obtenu.

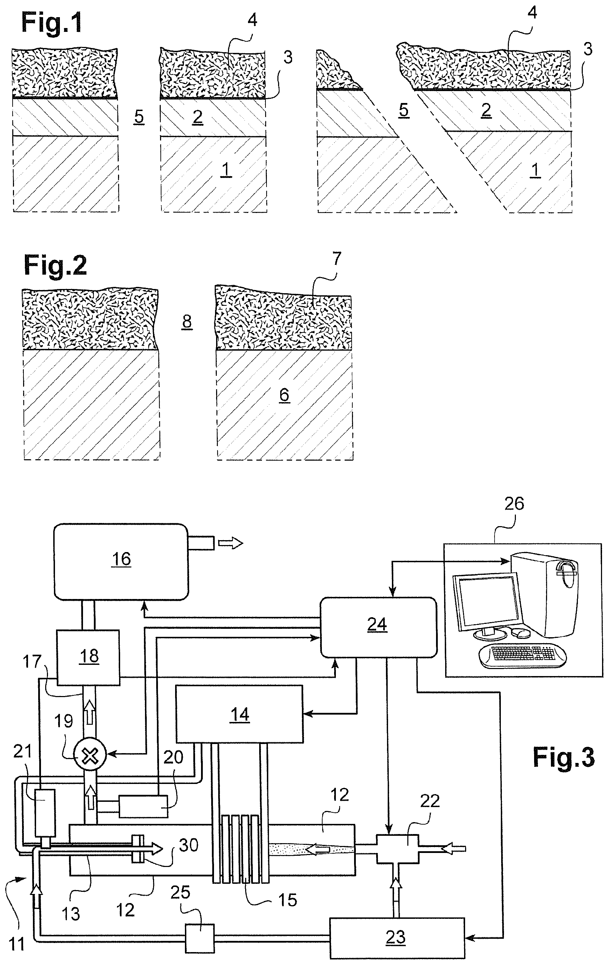

Comme illustré sur la figure 1, un composant 1 peut être une aube de turbine haute pression. Le composant 1 est réalisé en super alliage à base de nickel. Le composant 1 est revêtu sur sa face extérieure d'une couche de liaison 2 en alliage, par exemple en aluminiure de nickel modifié au platine. Le composant 1 est muni de canaux de refroidissement 5 débouchant en face extérieure. La couche de liaison 2 comprend une face extérieure revêtue d'une couche d'oxyde 3. La couche de liaison 2 présente une épaisseur comprise entre 10 et 100 $\mu$m, préférablement entre 20 et 50 $\mu$m. La couche de liaison 2 repose sur le superalliage à base de nickel 1. La couche d'oxyde 3 présente une face extérieure revêtue par la barrière thermique 4. La couche d'oxyde 3 présente une épaisseur comprise entre 0,1 et 1 $\mu$m, préférablement entre 0,3 et 0,6 $\mu$m. La couche d'oxyde 3 peut comprendre de l'alumine. La barrière thermique 4, par exemple de l'oxyde de zirconium partiellement stabilisée à l'oxyde d'yttrium, isole le superalliage des fortes températures régnant dans le turboréacteur tout en préservant les canaux de refroidissement. L'épaisseur de la barrière thermique 4 est comprise entre 100 et 150$\mu$m. Comme illustré sur la figure 2, un composant peut être une pièce percée 6 réalisée en acier inox. La pièce 6 est percée d'un trou 8 débouchant en face extérieure et est revêtue sur sa face extérieure d'une couche d'oxyde 7 protectrice. L'épaisseur de la couche d'oxyde 7 est comprise entre 5 et 150 $\mu$m. La couche d'oxyde 7 peut comprendre de l'oxyde de zirconium partiellement stabilisé à l'oxyde d'yttrium.

Comme on peut le voir sur la figure 3, le système comprend une chambre à plasma 12 dans laquelle est disposé un porte substrat 13. Le composant 30 peut être installé sur le porte substrat 13. Un générateur radio fréquence 14 alimente des spires inductives 15 disposées autour de la chambre à plasma 12. La masse électrique du générateur radio fréquence est reliée au porte substrat 13. Une pompe à vide 16 est reliée par une conduite 17 à l'intérieur de la chambre à plasma 12. Sur la conduite 17, sont prévus des filtres 18 permettant de capter les acides et les poussières et au moins une vanne commandée 19. Une jauge de pression 20 est montée sur la conduite 17 entre la chambre à plasma 12 et la vanne commandée 19.

La chambre à plasma 12 est équipée d'un dispositif d'introduction des gaz porteur et d'injection 22 des précurseurs de l'oxyde comportant une vanne. Le dispositif d'introduction 22 est également relié fluidiquement à un distributeur de fluides 23 muni au moins d'un débitmètre massique. Le dispositif d'introduction 22 comprend un capillaire de diamètre fixe ou réglable selon les besoins ou un nébuliseur éventuellement couplé à une vanne pour fournir du gaz porteur et des précurseurs dans la chambre à plasma 12. Une conduite 25 est montée entre le distributeur de fluide 23 et le porte substrat 13 en vue de fournir du fluide pour maintenir ouvert des perçages du composant à réparer. Une jauge de pression 21 est montée sur la conduite 25 entre le distributeur de fluide 23 et la chambre à plasma 12.

Un boîtier de commande, d'acquisition et de contrôle 24 est relié à des sorties des jauges de pression 20 et 21. Le boîtier de commande 24 comprend des sorties de commande reliées à la pompe à vide 16, au générateur radio fréquence 14, à la vanne commandée 19, au dispositif d'introduction 22 et au distributeur de fluide 23. Le boîtier 24 est également en communication avec un ordinateur 26 équipé d'une carte d'acquisition et stocke les données de mise en oeuvre de l'asservissement.

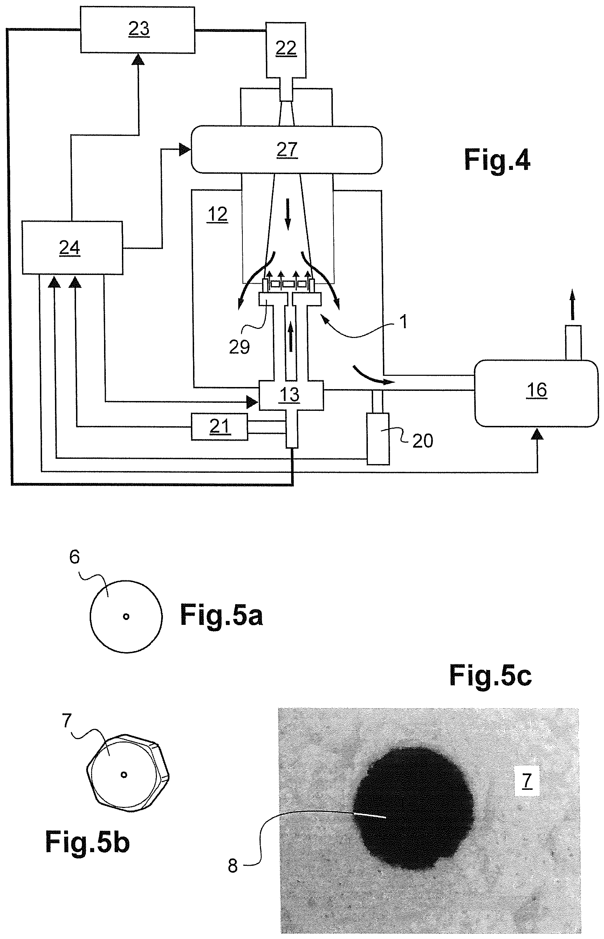

Sur la figure 4, certains éléments de la figure 3 ont été omis pour plus de lisibilité.

La figure 4 montre un schéma plus général du système pour mettre en oeuvre le procédé. Le système comprend une chambre à plasma 12 surmontée d'une source plasma 27 et équipée du dispositif d'introduction 22 La pompe à vide 16 permet de modifier la pression dans la chambre à plasma 12. La pression est contrôlée au niveau de la chambre à plasma 12 par une jauge 20 et au niveau du porte substrat 13 par une jauge 21. Le boîtier de commande 24 assure la commande et l'asservissement du procédé dans sa globalité. Le boîtier de commande 24 permet le contrôle des pressions et des débits de gaz porteur chargé en précurseurs de l'oxyde au niveau du distributeur de fluide 23 relié au dispositif d'introduction 22, et du débit de fluide injecté en amont du porte substrat 13 lequel est en contact étanche avec le composant perméable 30.

Sur le porte substrat 13 est monté un raccord 29 étanche supportant le composant perméable 30. Le raccord 29 est étanche en ce sens que l'écoulement de fluide provenant du porte substrat 13 ne peut s'écouler qu'au travers des pores du composant perméable 30.

En fonctionnement, la chambre à plasma reçoit simultanément un gaz, en provenance du composant perméable à revêtir et un gaz porteur chargé ou non de précurseurs de l'oxyde dans un plasma basse pression. Le fluide circulant au travers du composant perméable empêche le dépôt d'oxyde dans les pores.

Le composant à revêtir est réalisé en un matériau ou ensemble de matériaux stable à 400°C. La surface à revêtir du composant peut couvrir tout ou partie de la surface extérieure du composant. Au moins un pore de diamètre compris entre 50 et 1000 μm débouche sur la surface extérieure. On injecte un gaz porteur chargé de gouttelettes d'au moins un précurseur de l'oxyde dans un plasma basse pression au sein d'une enceinte de réacteur à plasma dans laquelle le composant est installé. On injecte un fluide passant par au moins un pore du composant à l'état gazeux. Le gaz s'écoule par le pore dans la chambre à plasma évitant le colmatage du pore. La pression du fluide en amont du composant perméable étant telle que la pression du gaz en sortie du pore est supérieure à la pression dans la chambre à plasma. On injecte un gaz porteur non chargé de précurseur de l'oxyde dans un plasma au sein de la chambre à plasma. On répète les étapes d'injection de gaz porteur chargé et non chargé, formant ainsi sur la surface extérieure ledit oxyde. Le diamètre du pore est préservé.

L'invention est illustrée en outre par les exemples suivants.

Exemple 1 :

Le composant perméable 30 à recouvrir d'une couche d'oxyde poreuse est ici un pion hexagonal 6 en acier inox (12 mm de cotés) percée en son centre d'un trou 8 de 0,6 mm de diamètre tel que présentée en figure 5a. Le trou doit rester libre pour la circulation d'un gaz à travers le pion. L'oxyde à déposer est par exemple de l'oxyde de zirconium partiellement stabilisée à l'oxyde d'yttrium La régulation du procédé est manuelle.

Le pion perméable à revêtir est fixé dans la chambre à plasma 12 représentée sur la figure 3, de diamètre égal à 50 mm, et connecté par l'intermédiaire d'un système étanche au porte substrat rotatif 13 et à un réseau de fluide constitué d'un tube interne en diamètre ¼ pouce, soit 6,35 mm. Le porte substrat peut être chauffé ou refroidi (10-600°C). Le plasma est généré dans la chambre à plasma par l'intermédiaire de 5 ou 6 spires inductives 15 dans lesquelles circule un courant électrique radio fréquence à 40 MHz. Le générateur 14 utilisé pour fournir ce courant est un générateur TOCCO-STEL qui peut transférer au gaz porteur des puissances comprises entre 60 et 600W. On peut diviser ce générateur en deux parties distinctes. La première partie est un compartiment qui crée un courant continu haute tension à partir du courant triphasé du secteur. I et U peuvent être lus sur les écrans du générateur. La deuxième partie est un compartiment produisant le courant haute fréquence (MHz) qui traverse les spires 15. Pour cela ledit compartiment est équipé d'une triode et muni d'un circuit oscillant de selfs et capacités. Le plasma peut être généré par des moyens soit capacitifs soit inductifs. Dans les conditions de transfert de puissance et de pression de cet exemple, le plasma apparaît comme étant généré par des moyens inductifs. Les spires 15 placées en amont du porte substrat entourent la chambre 12, par exemple un tube de quartz, et permettent d'initier et de maintenir un plasma. La chambre peut comprendre un tube de quartz. Le plasma en plus de contenir des réactifs chimiques excités et oxydants, va chauffer le flux de matière circulant dans la chambre à plasma.

Les conditions préalablement déterminées pour le dépôt de l'oxyde de zirconium stabilisé à l'oxyde d'yttrium sont des débits de gaz porteur (Ar : 2,1 L / min soit 6,2 $10^{-5}$ kg/s, $N_2$ : 0,275 L / min soit 5,7$10^{-6}$ kg/s, et $O_2$ : 0,22 L / min soit 5,2$10^{-6}$ kg/s dans les conditions Standard de Température (25°C) et de Pression (100000 Pa) - (STP) chargés par une solution aqueuse contenant les précurseurs de l'oxyde (l'oxynitrate hydraté de zirconium (IV) et le nitrate d'yttrium - rapport molaire 8,5 /1 ) injecté avec un débit de 0,7 mL / min. Le débit maximal de gaz porteur chargé en précurseurs de l'oxyde est donc de 7,3 $10^{-5}$ kg/s et la pression varie de 760 Pa (impulsion de gaz porteur non chargé en précurseur de l'oxyde) à 1000 Pa (impulsion de gaz porteur chargé en précurseur de l'oxyde).

Le démarrage du procédé passe tout d'abord par la mise en route du système de pompage (pompe à vide 16) pour mettre la chambre de dépôt en dépression (Pression : 500 Pa). La pression est contrôlée à l'aide d'une jauge MKSA 20. L'arrivée du fluide au niveau du porte substrat est ensuite ouverte et de l'air provenant de la salle d'expérimentation est alors aspiré. La surpression au niveau du porte substrat 13, en amont du pion, est alors égale à 10000 Pa. La surpression est contrôlée par une jauge de pression MKSA 21 branchée sur le système de circulation des fluides du porte substrat. L'entrée d'air qui se fait par le trou du pion entraîne alors une augmentation de la pression dans la chambre de dépôt jusqu'à une valeur de 700 Pa. La pression de l'air en sortie du trou est aux alentours de 10000 Pa car les pertes de charges sont faibles dans cette configuration (1 seul trou). Le débit d'air circulant est réglé à 1,38$10^{-5}$ kg/s (0,7L / min) (STP) grâce à un débitmètre massique contenu dans le distributeur de fluide 23. Ledit débit massique d'air de 1,38$10^{-5}$ kg/s est situé entre les deux bornes définies. Ledit débit massique d'air est inférieur au débit massique total des gaz porteurs chargés en précurseur de l'oxyde (7,3 $10^{-5}$ kg/s) entrant dans la chambre à plasma (borne supérieure). Ledit débit massique d'air est supérieur au produit de la valeur du débit massique total des gaz porteurs chargés en précurseur de l'oxyde entrant dans la chambre à plasma, par le rapport entre la surface totale des porosités ouvertes du pion perméable et la surface de la section de passage de la chambre à plasma, valeur égale à 7,3 $10^{-5}$ *$(0,6/50)^2$ = 1,06 $10^{-8}$ kg/s.

Le nombre de Reynolds s'exprime en fonction du débit massique $Q_{m\ STP}$ selon

$$Re = (Q_{m\ STP} * D)/(\mu * \text{Surface de la porosité ouverte})$$

Avec

$Q_{m\ STP}$ = débit massique en conditions **S**tandard de **P**ression et **T**empérature (ici $1,3810^{-5}$ kg/s)
D = diamètre représentatif du pore (ici 0,6 mm = 600 $10^{-6}$ mètre)
$\mu$ = viscosité dynamique du fluide injecté, ici $\mu_{air}$ égale à 2,1 $10^{-5}$ Pa à 10000 Pa,

et surface de la porosité ouverte égale ici à $\pi D^2/4$ en $m^2$
on détermine la valeur du nombre de Reynolds à Re= $(4 * Q_{m\ STP} * D)/(\mu * \pi D^2)$

$$Re = (4 * Q_{m\ STP})/(\mu * \pi D) = 1391$$

Le régime est bien laminaire car le nombre de Reynolds est inférieur à 2100.

Le générateur est ensuite allumé afin d'initier le plasma. La puissance du générateur délivrant les ondes électromagnétiques émises est ajustée dans cet exemple à une valeur de 200 W. Le dispositif d'introduction 22 est ensuite mis en route presque immédiatement pour introduire les gaz porteur (Ar : 2,1 L / min, $N_2$ : 0,275 L / min, et $O_2$ : 0,22 L / min en conditions STP) et la solution aqueuse contenant les précurseurs de l'oxyde (l'oxynitrate hydraté de zirconium (IV) et le nitrate d'yttrium - rapport molaire 8,5 /1 - débit 0,7 mL / min). Le système d'injection fonctionne de façon pulsée (actif pendant 0,2 s et inactif pendant 2s) et forme un jet de gaz porteur chargé dans la chambre à plasma qui comporte des gouttelettes de nitrates à l'état liquide / gel et de taille micrométrique. La pression dans la chambre à plasma augmente jusqu'à 1000 Pa lorsque le système d'injection est actif et redescend à 760 Pa lorsqu'il est inactif. L'étape d'injection pulsée des gaz porteur chargés en précurseurs d'oxyde se déroule pendant 2 minutes. Le plasma, alimenté par les gaz porteur chargés et par l'eau qui s'évapore, comporte des espèces de type O et OH qui vont agir sur l'oxydation des nitrates dans la chambre de dépôt. Les gouttelettes de précurseurs d'oxyde circulants avec le jet de gaz porteur chargé impactent le substrat et forment une couche d'oxyde du fait des propriétés oxydantes du plasma. Le débit d'air sortant par le trou du pion s'oppose naturellement au dépôt de la matière du fait de la surpression par rapport aux flux des gaz porteurs chargés et des gouttelettes qui lui sont opposés. Lors des essais, un constat d'absence de nitrates ayant pénétré ou s'étant infiltré dans le trou est fait. Le colmatage est évité. Le débit des nitrates est ensuite coupé de façon à ce que seul les gaz porteurs pénètrent dans la chambre à plasma par l'intermédiaire du système d'injection. Le débit d'air entrant dans le pion à recouvrir est maintenu. Cette étape de 8 minutes de durée est appelée « post traitement ». Cette étape vise à parfaire l'oxydation des nitrates déposés sur le pion à recouvrir (principalement action des O et des OH provenant de l'eau résiduelle dans la chambre à plasma et dans la couche d'oxyde). La température du pion à recouvrir ne dépasse pas les 400°C.

La vitesse de dépôt est comprise entre 15 et 25 $\mu$m / h. Les étapes injection / post traitement sont répétées n fois de façon à obtenir une couche d'oxyde de zirconium partiellement stabilisée à l'oxyde d'yttrium dont l'épaisseur est de l'ordre de 150 $\mu$m. Une fois l'oxyde déposé sur le pion percé, l'ensemble du dispositif est coupé (système électrique / gaz / dispositif de pompage). La chambre à plasma est remise à l'atmosphère puis le porte substrat est retiré de la chambre de dépôt. Le pion 6 qui était d'un aspect brillant inox avant le dépôt Figure 5a apparaît recouvert d'une couche blanche d'oxyde 7 avec un trou 8 bien visible en son centre (Figure 5c). Une fois libéré du porte substrat, le pion 6 recouvert est placé sous un microscope optique afin d'observer le trou 8 et la couche déposée 7. L'observation du trou 8 montre que son diamètre est égal à 600 $\mu$m, soit la même valeur que le diamètre du trou initial avant dépôt. Ceci signifie que le flux d'air sortant empêche le dépôt de commencer à colmater, même de manière modérée sur la périphérie, le trou 8 du pion 6 hexagonal. La couche obtenue après les cycles d'injection / post traitement présente en sortie de réacteur une structure cristalline bien visible sur les diffractogrammes alors que la température dans le plasma reste modérée.

Le dépôt d'oxyde subit enfin un recuit dont la température est égale à 1100 °C (chauffage / refroidissement 50 °C / h). Ce traitement thermique conserve le trou présent sur le pion recouvert. Le recuit permet d'éliminer les traces éventuelles de nitrates et d'eau et de parfaire la cristallisation du dépôt. Il est également à l'origine d'un processus de croissance et de stabilisation des grains constitutifs de la couche poreuse.

La méthode de dépôt évoquée ici permet donc de recouvrir un pion en inox 6 (Figure 5a) percé d'un trou 8 d'une couche d'oxyde 7 avec effet anti colmatage tant que ledit trou est traversé par un flux d'air pendant la phase de dépôt. La couche déposée sur le pion pour modifier ses propriétés de surface n'influence pas la présence ni la taille du trou. Celui-ci reste donc libre et peut continuer à remplir une fonction de drainage de gaz après le dépôt de la couche d'oxyde.

Exemple 2 :

On procède comme dans l'exemple 1 sauf que le composant est par exemple une aube de turbine haute pression. Ce peut être aussi une portion de chambre de combustion multi perforée d'un turboréacteur. L'aube, de surface 28 cm$^2$, présente des perforations de diamètre 0,5 mm sur 5% de la surface totale. L'aube doit être recouverte d'une barrière thermique typiquement un oxyde comme de l'oxyde de zirconium partiellement stabilisé à l'oxyde d'yttrium pour isoler le superalliage des fortes températures régnant dans le turboréacteur. L'oxyde doit donc recouvrir l'aube en respectant les perforations. L'aube est placée dans une chambre à plasma de diamètre 10 cm, (section de passage 78,5 cm$^2$), donc de plus grande taille que celle de l'exemple 1. Ce dispositif possède un système d'introduction des gaz porteur et réactifs redimensionné (fonctionnant sur le même principe que celui cité dans l'exemple 1) et est équipé d'un autre dispositif de création du plasma. Il comprend un système de génération et de transport de l'énergie micro-onde. L'énergie micro-onde est créée par deux générateurs micro-onde en mode pulsé (2,45 GHz) de type SAIREM GMP 20 KE/D de puissance ajustable de 200 à 10000 W chacun placés face à face. L'énergie est injectée par deux guides d'ondes en laiton disposé autours d'un tube en quartz surplombant la chambre de dépôt. Le couplage avec le gaz porteur est réalisé dans un excitateur cylindrique en acier. Le plasma est généré par des moyens capacitifs.

Un plasma d'argon/azote/oxygène/vapeur d'eau est amorcé dans les conditions suivantes : Puissance : 2600W Pression : 780 à 1000 Pa débit d'argon 2,1 L/min STP, débit d'azote 0,275 L/min STP, débit d'oxygène 0,22 L/min STP, débit d'eau : 1,5 ml/min par des injections pulsées de 2 minutes (selon le cycle suivant : ouverture de vanne pendant 0,2 seconde et temps de fermeture de la vanne 2 secondes), durée de 90 minutes, afin de créer une couche d'oxyde de type TGO d'épaisseur maximale 0,5 μm, avant de déposer l'oxyde choisi, ici de l'oxyde de zirconium partiellement stabilisé à l'oxyde d'yttrium.

Les conditions initiales pour le dépôt choisi sont un plasma d'argon/ oxygène avec un débit total de gaz porteur de 12 L / min STP. Le débit d'oxygène est de 5 L / min STP soit 1,2 10$^{-4}$ kg/s STP et le débit d'argon de 7 L / min STP soit 2,1 10$^{-4}$ kg/s STP avec un débit des précurseurs oxynitrate hydraté de zirconium (IV) et nitrate d'yttrium égale à 20 ml / min. La pression de la chambre à plasma varie jusqu'à 10000 Pa (impulsion de gaz porteur chargé en précurseur de l'oxyde).

La pression en amont de l'aube perméable à recouvrir est fixée égale à 20 000 Pa.

Le débit d'air injecté au travers de l'aube perméable est égal à 5 L / min STP soit un débit massique de 0,98 10$^{-4}$ kg/s.

Le débit massique d'air injecté est inférieur à la valeur du débit massique total de gaz porteur chargé de précurseurs de l'oxyde (3,3 10$^{-4}$ kg/s) - borne maximale - et est supérieur à la valeur du débit massique total des gaz porteur chargés en précurseur de l'oxyde entrant dans la chambre à plasma multiplié par le rapport entre la surface totale des porosités ouvertes de l'aube perméable et la surface de la section de passage de la chambre à plasma, valeur égale à 3,3 10$^{-4}$ g/s *[(0,05*28)/(78,5)] = 5,8 10$^{-6}$ kg/s - borne inférieure.

Par un calcul équivalent à l'exemple 1 on vérifie que le nombre de Reynolds (ici 14) est bien inférieur à 2100.

Après n cycles d'injection / post traitement, et en appliquant la régulation sur les pressions et débits telle que décrite précédemment, on obtient sur l'aube une barrière thermique de type oxyde de zirconium partiellement stabilisée à l'oxyde d'yttrium avec les trous de refroidissement conservés comme l'illustre la figure 1.

La méthode de dépôt décrite ici permet donc d'isoler thermiquement par un oxyde de zirconium partiellement stabilisé à l'yttrium 4 un superalliage 1 préalablement recouvert d'une couche de liaison 2 tout en préservant les circuits de refroidissement 5 perpendiculaires ou non à la surface. Les circuits de refroidissement 5-restent ouverts après formation de l'oxyde 3 et dépôt de l'oxyde.

Exemple 3

On procède comme dans l'exemple 2 sauf que le composant est une section de chambre de combustion constituée d'une mousse métallique base nickel poreuse comportant des trous de diamètre compris entre 50 et 500 μm sur une surface équivalente à 30% de la section de chambre. La section de chambre de surface 30 cm$^2$ doit être recouverte d'une barrière thermique, typiquement de l'oxyde de zirconium partiellement stabilisé à l'oxyde d'yttrium. Le protocole d'opération est le même que celui cité dans l'exemple 2, la régulation du débit massique de fluide injecté dans la section de chambre perméable et de la pression en sortie des trous prenant en compte le fait que la section de chambre est une mousse avec une porosité surfacique élevée (calcul de la borne inférieure). On obtient des résultats identiques à ceux présentés dans l'exemple 2 à savoir que les porosités ouvertes sont conservées (non colmatées) tandis que la barrière thermique recouvre bien la mousse.

Exemple 4

On procède comme dans l'exemple 2 sauf que le composant est une section de chambre de combustion constituée d'un alliage base cobalt, de sa couche de liaison et d'une barrière thermique d'oxyde de zirconium partiellement stabilisé à l'oxyde d'yttrium, et comportant des canaux de refroidissement débouchants en surface selon un diamètre de 500 $\mu$m. Certaines zones de la section de chambre doivent être recouvertes d'un oxyde protecteur, appelé également barrière environnementale, comme par exemple le zirconate de gadolinium $Gd_2Zr_2O_7$ ou le zirconate de néodyme $Nd_2Zr_2O_7$, afin d'éviter localement la dégradation de la section de chambre par des agents agressifs type silicates d'aluminium, de silicium et de magnésium susceptibles d'être présents dans les turbines de moteur. Les conditions de dépôt de l'oxyde protecteur doivent conserver les canaux de refroidissement de la section de chambre ouverts en évitant leur colmatage. Les parties de la section de chambre que l'on ne veut pas recouvrir de $Gd_2Zr_2O_7$ sont masquées, par exemple avec une feuille d'aluminium. Les conditions de dépôt de $Gd_2Zr_2O_7$ sont les mêmes que celles citées dans l'exemple 2, à l'exception de l'étape de formation d'une couche d'oxyde type TGO, non appliquée ici, et des précurseurs injectés qui sont ici l'oxynitrate hydraté de zirconium (IV) $ZrO(NO_3)_2,6H_2O$ et le nitrate hydraté de gadolinium $Gd(NO_3)_3,6H_2O$ ou le nitrate hydraté de néodyme $Nd((NO_3)_3,6H_2O$. On obtient des résultats identiques à ceux présentés dans l'exemple 2 à savoir que les porosités ouvertes sont intactes.

Exemple 5

Il s'agit d'un exemple de réparation de composant usagé.

Le composant est par exemple une aube d'une turbine haute pression d'un turboréacteur possédant des canaux de refroidissements de diamètre moyen 500 $\mu$m débouchant typiquement au niveau du bord d'attaque et du bord de fuite.

La couche externe de barrière thermique est élaborée par EB-PVD et comprend de l'oxyde de zirconium partiellement stabilisé à l'oxyde d'yttrium (YpSZ). L'épaisseur de la barrière thermique est comprise entre 100 et 150 $\mu$m. La couche externe de barrière thermique repose sur une couche d'oxyde appelée TGO (Thermally Growth Oxide) d'épaisseur 0,5 $\mu$m, par exemple. La couche d'oxyde a été créée in situ lors du dépôt de la barrière thermique YpSZ. La couche d'oxyde repose elle-même sur une couche interne, par exemple un aluminiure de nickel modifié platine ou dopé zirconium. L'épaisseur de la couche interne est comprise entre 20 et 50 $\mu$m. La couche interne repose elle-même sur le superalliage monocristallin à base de nickel.

Après fonctionnement l'aube présente parfois des écaillages de quelques $mm^2$ à quelques $cm^2$ avec de nombreuses fissures longitudinales de délaminage entre la barrière thermique et le substrat.

Un sablage léger de l'aube, par exemple un sablage sec réalisé avec du corindon, est alors réalisé afin de nettoyer l'aube des portions de barrière thermique non adhérentes. Puis l'aube est placée dans la chambre à plasma basse pression du système décrit dans l'exemple 2 et raccordée au porte substrat comme dans l'exemple 2. Les parties saines de l'aube que l'on ne veut pas réparer peuvent être protégées par un masque, par exemple une feuille d'aluminium. L'aube subit une série de nettoyages dans la chambre à plasma telle que décrite ci-dessous.

Le générateur est allumé afin d'initier le plasma (t0). Un plasma d'hydrogène est alors créé afin d'opérer le nettoyage de l'aube dans les conditions suivantes : Puissance du générateur qui délivre des ondes électromagnétiques émises : 2000W, Pression : 560 à 650 Pa, débit d'argon 1,8 L/min STP, débit d'azote 0,215L/min STP, débit d'hydrogène 0,1L/min STP, durée : 25 minutes. La région à réparer étant alors débarrassée des impuretés et composés peu adhérents, la couche d'oxyde promotrice d'adhésion est formée. Un plasma d'argon/azote/oxygène/vapeur d'eau est amorcé dans les conditions suivantes : Puissance : 2600W Pression : 780 à 1000 Pa débit d'argon 2,1 L/min STP, débit d'azote 0,275 L/min STP, débit d'oxygène 0,22 L/min STP, débit d'eau : 1,5 ml/min par des injections pulsées de 2 minutes (selon le cycle suivant : ouverture de vanne pendant 0,2 seconde et temps de fermeture de la vanne 2 secondes), durée de 90 minutes, afin de recréer la couche d'oxyde TGO dans les endroits où elle s'est décollée. On conserve le plasma d'argon/azote/oxygène dans les conditions précitées. La pression du réacteur est alors augmentée jusqu'à 5300 Pa, le débit massique du fluide injecté dans l'aube perméable est conservé égal au débit massique total des gaz porteur chargés des précurseurs de l'oxyde, la pression en amont de l'aube à revêtir étant supérieure de 2000 Pa à la pression du réacteur, la puissance du générateur étant comprise entre 2000 et 2600W et une solution d'oxynitrate hydraté de zirconium et de nitrate d'yttrium ($ZrO(NO_3)_2$ $6H_2O$ et $Y(NO_3)_2$ (rapport molaire 8,5/1)) est pulvérisée (diamètre du capillaire 500 $\mu$m), avec un débit de 1,5 $cm^3$/min, par des injections pulsées de 2 minutes (selon le cycle suivant : ouverture de vanne pendant 0,2 seconde et temps de fermeture de la vanne 2 secondes) dans le plasma (t1-t2). La conductivité et le pH de la solution injectée sont mesurés en continu.

Au cours de cette étape, les nitrates de zirconium et d'yttrium subissent l'action des espèces O et OH aussi bien en vol que sur le substrat. Les conditions de pression dans la chambre à plasma et de puissance générée par la chambre à plasma associées à la taille des gouttelettes produites par l'injecteur, font que les nitrates arrivent sur le substrat à l'état liquide et peuvent s'infiltrer dans les fissures longitudinales et dans les fissures de délaminage entre le substrat et la barrière thermique.

Puis on procède à une étape de post traitement d'une durée de l'ordre de 8 minutes consistant à maintenir les débits de gaz porteur plasmagènes et le plasma allumé. Ainsi, les nitrates de zirconium et d'yttrium qui se sont déposés dans et sur le substrat subissent encore la chimie oxydante du plasma, principalement l'action des O, puisque la solution n'est plus introduite pendant cette étape. En outre, on peut également alimenter la chambre à plasma en eau de façon à produire des radicaux OH pendant le post traitement. La température au niveau du porte substrat reste inférieure à 400 °C

On répète 10 fois les cycles injection / post traitement puis la pression du réacteur est diminuée de 200 Pa en début de chaque cycle d'introduction du gaz porteur chargé en précurseurs de l'oxyde jusqu'au 20^{ème} cycle ou l'épaisseur d'oxyde déposé est satisfaisante pour la réparation.

A chaque début de cycle le débit massique d'introduction du fluide au travers de l'aube est contrôlé de manière à rester dans le domaine laminaire malgré la diminution de pression dans la chambre à plasma, tout en étant supérieur au débit massique du gaz porteur chargé de précurseurs de l'oxyde multiplié par le rapport de la surface totale des porosités ouvertes de l'aube perméable à la section de passage de la chambre à plasma Le procédé décrit ci-dessus permet de réparer localement la barrière thermique, tout en conservant les canaux de refroidissement, en recréant sur la sous-couche une couche d'oxyde là où la barrière thermique initiale et la TGO initiale se sont décollées et en infiltrant une nouvelle couche de céramique permettant ainsi le recollage de la barrière thermique initiale. Ceci évite l'opération de reperçage des trous.

Exemple 6

On procède comme dans l'exemple 5 sauf que le débit massique de fluide est introduit dans l'aube perméable à la fin de l'étape de nettoyage à l'hydrogène et avant l'étape de pré-oxydation pour recréer l'oxyde de type TGO.

Le procédé est alors asservi de telle sorte que le débit massique de fluide circulant à travers l'aube est régulé par le boîtier de commande 24. Le programme de commande de l'ordinateur 26, agit sur le système d'injection 22 via le boîtier de commande 24, de telle sorte que le débit massique de fluide circulant à travers l'aube perméable soit compris entre les bornes minimale et maximale et que sa valeur génère de préférence un nombre de Reynolds inférieur à 2100.

**Revendications**

1. Procédé de formation d'une couche d'oxyde sur un composant perméable réalisé en un matériau ou un empilement de matériaux stable à 400°C, ledit composant comprenant une surface extérieure à revêtir et au moins un pore de diamètre compris entre 50 et 1000 $\mu$m débouchant sur ladite surface extérieure, comprenant les étapes suivantes :

   a) Injection d'un gaz porteur chargé de gouttelettes d'au moins un précurseur de l'oxyde dans un plasma basse pression au sein d'une enceinte de réacteur à plasma logeant le composant à revêtir, et injection d'un fluide passant par le composant perméable et s'écoulant à l'état gazeux par ledit au moins un pore à flux opposé à celui du gaz porteur dans la chambre à plasma pour éviter le colmatage du pore, la pression et le débit massique dudit fluide en amont du composant perméable étant tels que la pression du gaz en sortie du au moins un pore est supérieure à la pression dans la chambre à plasma et que le débit massique d'injection du fluide passant par le composant perméable est :

   $\alpha$) au maximum égal au débit massique du gaz porteur chargé en précurseurs de l'oxyde injecté dans la chambre à plasma ; et
   $\beta$) au minimum égal au produit du débit massique du gaz porteur chargé en précurseurs de l'oxyde injecté dans la chambre à plasma par le rapport entre la surface totale des porosités ouvertes du composant perméable et la surface de la section de passage de la chambre à plasma ;

   ainsi, la vitesse du gaz à la sortie du au moins un pore est supérieure ou égale à la vitesse d'arrivée du gaz porteur chargé d'au moins un précurseur de l'oxyde à l'état indifféremment - liquide, gel ou solide - à la surface extérieure du composant,
   b) Injection d'un gaz porteur non chargé de précurseur de l'oxyde dans un plasma au sein de la chambre à plasma, l'injection du fluide passant par le composant perméable étant maintenu

   les étapes a) et b) étant répétées, pour former sur la surface extérieure ledit oxyde, le diamètre du au moins un pore étant préservé.

2. Procédé selon la revendication 1, dans lequel, à l'étape a), l'injection du fluide passant par le composant perméable est effectuée tout en commandant, la pression du fluide en amont du composant perméable, le débit massique du gaz porteur chargé de gouttelettes de précurseur de l'oxyde, et la pression dans la chambre à plasma.

**3.** Procédé selon la revendication 2, dans lequel un asservissement entre la pression du fluide injecté, en amont du composant, la pression de la chambre à plasma et le débit massique du gaz porteur chargé en précurseurs de l'oxyde est mis en oeuvre afin de piloter le débit massique du fluide injecté dans le composant perméable dans les bornes définies en $\alpha$) et $\beta$) tout en conservant de préférence un nombre de Reynolds inférieur à 2100 quel que soit le débit massique du gaz porteur chargé en précurseurs de l'oxyde.

**4.** Procédé selon l'une des revendications précédentes, dans lequel le fluide passant par le composant perméable est à l'état gazeux et le précurseur à l'état liquide, gel ou solide.

**5.** Procédé selon l'une des revendications précédentes, dans lequel la pression dans la chambre à plasma est comprise entre 1 et 20000 Pa, préférablement entre 100 et 10000 Pa.

**6.** Procédé selon l'une des revendications précédentes, dans lequel la pression du fluide passant par le composant perméable est comprise entre 10 et 40000 Pa, préférablement entre 200 et 20000 Pa.

**7.** Procédé selon l'une des revendications précédentes, dans lequel un générateur d'ondes électromagnétiques mis en oeuvre pour créer le plasma est réglé afin de transférer au plasma une puissance comprise entre 60 et 20000 W, préférablement entre 200 et 10000 W.

**8.** Procédé selon l'une des revendications précédentes, dans lequel le composant perméable présente des pores ouverts de diamètre compris entre 50 et 1000 $\mu$m.

**9.** Procédé selon l'une des revendications précédentes, dans lequel les gouttelettes présentent un diamètre compris entre 100 nm et 2 mm à l'état liquide, gel ou solide.

**10.** Procédé selon l'une des revendications précédentes, dans lequel la température du composant perméable reste inférieure à 400°C.

**11.** Procédé selon l'une des revendications précédentes, dans lequel le précurseur de l'oxyde est un précurseur de céramique comprenant au moins un organo-métallique, préférablement nitrate, acétate et/ou chlorure.

**12.** Procédé selon l'une des revendications précédentes, dans lequel le composant est neuf.

**13.** Procédé selon l'une des revendications 1 à 12, dans lequel le composant est en réparation.

**14.** Procédé selon l'une des revendications précédentes, dans lequel le composant comprend un superalliage à base choisie parmi au moins un de nickel, cobalt, fer, cuivre, aluminium, niobium.

**15.** Système de mise en oeuvre du procédé de dépôt d'oxyde selon l'une des revendications précédentes comprenant :

une chambre à plasma (12),
une source plasma (27) générant un plasma basse pression dans la chambre à plasma (12),
un dispositif d'injection (22) de gaz porteur de précurseurs de l'oxyde, dans la chambre à plasma (12),
un dispositif d'injection (21) de fluide,
un porte substrat (13) alimenté par le dispositif d'injection de fluide (21), porte substrat sur lequel est installé un composant perméable (30) comprenant une surface à revêtir, le porte substrat étant muni d'une conduite pour fournir un fluide provenant du dispositif d'injection de fluide (21) et traversant le composant et sortant à l'état gazeux par ladite surface à revêtir, tel que le flux du gaz porteur est opposé au flux du gaz sortant de la surface à revêtir,
une pompe à vide (16) permettant de modifier la pression dans la chambre à plasma (12),
une jauge (20) de contrôle de la pression au niveau de la chambre à plasma (12) une jauge (21) de contrôle de la pression au niveau du porte substrat (13), et
un boîtier de commande (24) assurant la commande et l'asservissement du procédé, permettant le contrôle des pressions et des débits de gaz porteur chargé en précurseurs de l'oxyde au niveau d'un distributeur de fluide (23) relié au dispositif d'injection (22), et du débit de fluide injecté en amont du porte substrat (13) lequel est apte à un contact étanche avec le composant perméable (30).

**Patentansprüche**

1. Verfahren zur Bildung einer Oxidschicht auf einer durchlässigen Komponente, die aus einem bei 400 °C stabilen Material oder Materialstapel hergestellt ist, wobei die Komponente eine zu beschichtende Außenfläche und wenigstens eine Pore mit einem Durchmesser zwischen 50 und 1000 $\mu$m aufweist, die in der Außenfläche mündet, umfassend die folgenden Schritte:

   a) Einspritzen eines mit Tröpfchen von wenigstens einem Vorläufer des Oxids beladenen Trägergases in ein Niederdruckplasma im Inneren eines Plasmareaktorgehäuses, das die zu beschichtende Komponente aufnimmt, und Einspritzen eines Fluids, das durch durchlässige Komponente strömt und in gasförmigem Zustand in einer Strömungsrichtung, die jener des Trägergases entgegengesetzt ist, durch die wenigstens eine Pore fließt, in die Plasmakammer, um eine Verstopfung der Pore zu verhindern, wobei der Druck und der Massendurchsatz des Fluids stromaufwärts von der durchlässigen Komponente derart sind, dass der Druck des Gases beim Verlassen der wenigstens einen Pore höher als der Druck in der Plasmakammer ist und dass der Massendurchsatz beim Einspritzen des durch die durchlässige Komponente strömenden Fluids wie folgt ist:

   $\alpha$) höchstens gleich dem Massendurchsatz des in die Plasmakammer eingespritzten, mit Oxidvorläufern beladenen Trägergases; und
   $\beta$) wenigstens gleich dem Produkt aus dem Massendurchsatz des in die Plasmakammer eingespritzten, mit Oxidvorläufern beladenen Trägergases und dem Verhältnis zwischen der Gesamtfläche der offenen Porositäten der durchlässigen Komponente und der Oberfläche des Durchlassquerschnitts der Plasmakammer;

   womit die Geschwindigkeit des Gases beim Verlassen der wenigstens einen Pore höher als die oder gleich der Geschwindigkeit des mit wenigstens einem Oxidvorläufer in gleich welchem Zustand - flüssig, gelförmig oder fest - beladenen Trägergases beim Eintreffen an der Außenfläche der Komponente ist,
   b) Einspritzen eines nicht mit einem Oxidvorläufer beladenen Trägergases in ein Plasma im Inneren der Plasmakammer, wobei die Einspritzung des durch die durchlässige Komponente strömenden Fluids aufrechterhalten wird,

   wobei die Schritte a) und b) wiederholt werden, um an der Außenfläche das Oxid zu bilden, wobei der Durchmesser der wenigstens einen Pore beibehalten wird.

2. Verfahren nach Anspruch 1, wobei im Schritt a) die Einspritzung des durch die durchlässige Komponente strömenden Fluids erfolgt, während der Druck des Fluids stromaufwärts von der durchlässigen Komponente, der Massendurchsatz des mit Oxidvorläufer-Tröpfchen beladenen Trägergases und der Druck in der Plasmakammer gesteuert werden.

3. Verfahren nach Anspruch 2, wobei eine Regelung zwischen dem Druck des eingespritzten Fluids stromaufwärts von der Komponente, dem Druck der Plasmakammer und dem Massendurchsatz des mit Oxidvorläufern beladenen Trägergases durchgeführt wird, um den Massendurchsatz des in die durchlässige Komponente eingespritzten Fluids innerhalb der in $\alpha$) und $\beta$) definierten Grenzen zu steuern, wobei unabhängig vom Massendurchsatz des mit Oxidvorläufern beladenen Trägergases vorzugsweise eine Reynolds-Zahl von unter 2100 aufrechterhalten wird.

4. Verfahren nach einem der vorhergehenden Ansprüche, wobei das durch die durchlässige Komponente strömende Fluid im gasförmigen Zustand ist und der Vorläufer im flüssigen, gelförmigen oder festen Zustand ist.

5. Verfahren nach einem der vorhergehenden Ansprüche, wobei der Druck in der Plasmakammer zwischen 1 und 20.000 Pa, vorzugsweise zwischen 100 und 10 000 Pa beträgt.

6. Verfahren nach einem der vorhergehenden Ansprüche, wobei der Druck des durch die durchlässige Komponente strömenden Fluids zwischen 10 und 40 000 Pa, vorzugsweise zwischen 200 und 20 000 Pa beträgt.

7. Verfahren nach einem der vorhergehenden Ansprüche, wobei ein Generator elektromagnetischer Wellen, der angewendet wird, um das Plasma zu erzeugen, derart geregelt wird, dass eine Leistung zwischen 60 und 20.000 W, vorzugsweise zwischen 200 und 10 000 W, zum Plasma übertragen wird.

8. Verfahren nach einem der vorhergehenden Ansprüche, wobei die durchlässige Komponente offene Poren mit einem Durchmesser zwischen 50 und 1000 μm aufweist.

9. Verfahren nach einem der vorhergehenden Ansprüche, wobei die Tröpfchen im flüssigen, gelförmigen oder festen Zustand einen Durchmesser zwischen 100 nm und 2 mm aufweisen.

10. Verfahren nach einem der vorhergehenden Ansprüche, wobei die Temperatur der durchlässige Komponente unter 400 °C bleibt.

11. Verfahren nach einem der vorhergehenden Ansprüche, wobei der Oxidvorläufer ein Keramikvorläufer ist, der wenigstens eine organometallische Verbindung, vorzugsweise ein Nitrat, Acetat und/oder Chlorid, umfasst.

12. Verfahren nach einem der vorhergehenden Ansprüche, wobei die Komponente neu ist.

13. Verfahren nach einem der Ansprüche 1 bis 12, wobei die Komponente in Reparatur ist.

14. Verfahren nach einem der vorhergehenden Ansprüche, wobei die Komponente eine Superlegierung umfasst, deren Basis aus wenigstens einem von Nickel, Kobalt, Eisen, Kupfer, Aluminium, Niob ausgewählt ist.

15. System zur Durchführung des Verfahrens zur Oxidablagerung nach einem der vorhergehenden Ansprüche, umfassend:

   eine Plasmakammer (12),
   eine Plasmaquelle (27), die ein Niederdruckplasma in der Plasmakammer (12) erzeugt,
   eine Vorrichtung (22) zum Einspritzen von Oxidvorläufer-Trägergas in die Plasmakammer (12),
   eine Fluideinspritzungsvorrichtung (21),
   einen Substratträger (13), der durch die Fluideinspritzungsvorrichtung (21) gespeist wird,
   wobei auf dem Substratträger eine durchlässige Komponente (30) angebracht ist, die eine zu beschichtende Oberfläche umfasst, wobei der Substratträger mit einer Leitung versehen ist, um ein Fluid bereitzustellen, das aus der Fluideinspritzungsvorrichtung (21) stammt und die Komponente durchquert und in gasförmigem Zustand durch die zu beschichtende Oberfläche austritt, derart, dass der Strom des Trägergases dem Strom des Gases entgegengesetzt ist, das aus der zu beschichtenden Oberfläche austritt,
   eine Vakuumpumpe (16), die es ermöglicht, den Druck in der Plasmakammer (12) zu verändern,
   eine Messvorrichtung (20) zur Überwachung des Drucks im Bereich der Plasmakammer (12),
   eine Messvorrichtung (21) zur Überwachung des Drucks im Bereich des Substratträgers (13), und
   einen Steuerkasten (24), der die Steuerungs- und Regelungsvorgänge des Verfahren gewährleistet und die Überwachung der Drücke und Durchsätze des mit Oxidvorläufern beladenen Trägergases im Bereich eines mit der Einspritzvorrichtung (22) verbundenen Fluidverteilers (23) und des Durchsatzes des eingespritzten Fluids stromaufwärts vom Substratträger (13) ermöglicht, der für einen dichten Kontakt mit der durchlässigen Komponente (30) geeignet ist.

**Claims**

1. A method of forming a layer of oxide on a permeable component made of a material or a stack of materials that is stable at 400°C, said component comprising an outer surface to be coated and at least one pore having diameter between 50 and 1000 μm unblocking at said outer surface, comprising the following steps:

   a) Injecting a carrier gas loaded with droplets of at least one precursor of the oxide in a low-pressure plasma inside an enclosure of a plasma reactor housing the component to be coated, and injecting a fluid passing through the permeable component and flowing in the gaseous state through at least one pore with flow opposite that of the carrier gas in the plasma chamber to prevent clogging the pore, the pressure and the mass flow rate of said fluid upstream of the permeable component being such that the pressure of the gas at the outlet of the at least one pore is greater than the pressure in the plasma chamber and that the injection mass flow rate of the fluid passing through the permeable component is:

   α) less than or equal to the mass flow rate of the carrier gas loaded with oxide precursors injected into the plasma chamber; and
   β) greater than or equal to the product of the mass flow rate of the carrier gas loaded with oxide precursors injected into the plasma chamber by the ratio between the total surface area of the open pores of the permeable component and the surface area of the passage section of the plasma chamber;

accordingly, the speed of the gas at the outlet of the at least one pore is greater than or equal to the intake speed of the carrier gas loaded with at least one precursor of the oxide in any of these states - liquid, gel or solid - on the outer surface of the component,
b) Injecting a carrier gas not loaded with oxide precursor in a plasma within the plasma chamber, injecting the fluid passing through the permeable component being maintained

steps a) and b) being repeated, to form on the outer surface said oxide, the diameter of the at least one pore being preserved.

2. The method as claimed in claim 1, wherein, in step a), the injection of the fluid passing through the permeable component is conducted by controlling the pressure of the fluid upstream of the permeable component, the mass flow rate of the carrier gas loaded with droplets of the oxide precursor, and the pressure in the plasma chamber.

3. The method as claimed in claim 2, wherein a controller between the pressure of the fluid injected, upstream of the component, the pressure of the plasma chamber and the mass flow rate of the carrier gas loaded with oxide precursors is used to control the mass flow rate of the fluid injected into the permeable component in the limits defined in $\alpha$) and $\beta$) while preferably retaining a Reynolds number below 2 100 regardless of the mass flow rate of the carrier gas loaded with oxide precursors.

4. The method as claimed in one of the previous claims, wherein the fluid passing through the permeable component is in the gaseous state and the precursor is in the liquid, gel or solid state.

5. The method as claimed in one of the previous claims, wherein the pressure in the plasma chamber is between 1 and 20 000 Pa, preferably between 100 and 10 000 Pa.

6. The method as claimed in one of the previous claims, wherein the pressure of the fluid passing through the permeable component is between 10 and 40 000 Pa, preferably between 200 and 20 000 Pa.

7. The method as claimed in one of the previous claims, wherein an electromagnetic wave generator used to create the plasma is regulated to transfer to the plasma a power between 60 and 20 000 W, preferably between 200 and 10 000 W.

8. The method as claimed in one of the previous claims, wherein the permeable component has open pores with diameter between 50 and 1 000 $\mu$m.

9. The method as claimed in one of the previous claims, wherein the droplets have a diameter between 100 nm and 2 mm in the liquid, gel or solid state.

10. The method as claimed in one of the previous claims, wherein the temperature of the permeable component remains below 400°C.

11. The method as claimed in one of the previous claims, wherein the oxide precursor is a ceramic precursor comprising at least one organometallic, preferably nitrate, acetate and/or chloride.

12. The method as claimed in one of the previous claims, wherein the component is new.

13. The method as claimed in one of claims 1 to 12, wherein the component is being repaired.

14. The method as claimed in one of the previous claims, wherein the component comprises a superalloy with a base chosen from at least one of nickel, cobalt, iron, copper, aluminum, niobium.

15. A system for using the method of depositing the oxide as claimed in one of the previous claims comprising:

a plasma chamber (12),
a plasma source (27) generating a low-pressure plasma in the plasma chamber (12),

a device (22) for injecting a carrier gas of oxide precursors into the plasma chamber (12),

a device (21) for injecting a fluid,

a substrate carrier (13) fed by the device (21) for injecting fluid, a substrate carrier on which is installed a permeable component (30) comprising a surface to be coated,

the substrate carrier being equipped with a pipe to provide a fluid coming from the fluid injection device (21) and passing through the component and exiting in the gaseous state through said surface to be coated, such that the flow of the carrier gas opposes the flow of the gas exiting the surface to be coated,

a vacuum pump (16) whereby the pressure can be changed in the plasma chamber (12),

a gauge (20) for controlling the pressure in the plasma chamber (12) a gauge (21) for controlling the pressure in the substrate carrier (13), and

a control case (24) that commands and controls the method, allowing the control of pressures and flow rates of carrier gas loaded with oxide precursors in a fluid distributor (23) connected to the injection device (22), and of the flow rate of fluid injected upstream of the substrate carrier (13) which can make a seal with the permeable component (30).

# Fig.1

# Fig.2

# Fig.3

**Fig.4**

**Fig.5a**

**Fig.5c**

**Fig.5b**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 7670112 B
- US 6126396 A
- US 5775108 A
- EP 0892218 A
- US 6025034 A
- US 20030077398 A
- FR 2695944
- US 5585136 A
- US 6408610 B
- US 4743462 A
- US 5985122 A
- US 6258226 B

- US 5565035 A
- US 5800695 A
- US 6004620 A
- US 6210488 B
- US 5702288 A
- US 5216808 A
- EP 1010772 A
- US 6365013 B
- US 4402992 A
- FR 130061944
- FR 2729400

**Littérature non-brevet citée dans la description**

- **S. ANGEL et al.** *High temperature material process,* 2007, vol. 11, 321-342
- **ROUSSEAU.** Deposition of thick and 50% porous Yp-SZ layer by spraying nitrate solution in a low pressure plasma reactor. *Surface and Coating Technology,* 2011, vol. 206 (7), 1621-1627

- Synthèse d'oxydes par plasma. Mise au point d'un réacteur plasma pour les tests de résistante au CMAS. *Thèse de doctorat de l'Université Pierre et Marie Curie,* 29 Novembre 2011